# EUROPEAN PATENT APPLICATION

(11) **EP 4 030 297 A1**
(43) Date of publication of application: **20.07.2022**
(21) Application number: 20875272.5
(22) Date of filing: 25.09.2020
(51) Int. Cl.: G06F 11/30

(54) **POWER DISPLAY METHOD AND APPARATUS, ELECTRONIC DEVICE, AND COMPUTER STORAGE MEDIUM**

(30) Priority: 09.10.2019 CN 201910955918
(71) Applicant: GUANGDONG OPPO MOBILE TELECOMMUNICATIONS CORP., LTD., Dongguan, Guangdong 523860 (CN)
(72) Inventor: HUANG, Tongfeng, Dongguan, Guangdong 523860 (CN)
(74) Representative: Fassio, Valeria
(86) International application number: PCT/CN2020/117937
(87) International publication number: WO 2021/068768

(57) **Abstract**

A power display method and apparatus, an electronic device, and a computer storage medium. The power display method comprises: obtaining the charging current of an electronic device; according to the charging current, calculating the expected increment of the power of the electronic device; and according to the expected increment of the power of the electronic device, updating the power display of the electronic device, wherein the power display uses a percentage form.

## Description

### TECHNICAL FIELD

The disclosure relates to the technical field of electronic devices, and particularly to a method for displaying a battery level and apparatus, an electronic device and a computer storage medium.

### BACKGROUND

With the quickening pace of modern life and the increase of efficiency, the user desire higher charging speed of the electronic device, and the fast charging technology greatly improves the user experience. During the charging process of the electronic device, the battery level measured by a power meter is acquired and displayed on the display screen for the user to view the charging process.

However, the update speed of the power meter is slow, which causes the user cannot to acquire the accurate current battery level.

### SUMMARY

A method for displaying a battery level provided by the embodiments of the disclosure can improve the accuracy of the displayed battery level.

In order to solve the technology problem described above, the embodiments of the disclosure adopt the following technical solutions.

According to an aspect of the disclosure, the embodiments of the disclosure provide a method for displaying a battery level, which includes the operations as follows. A charging current of an electronic device is acquired. An estimated increment of the battery level of the electronic device is obtained based on the charging current. A battery indicator of the electronic device is updated based on the estimated increment of the battery level of the electronic device, where the battery indicator is configured to display the battery level and presented in percentage.

According to another aspect of the disclosure, the embodiments of the disclosure provide an apparatus for displaying a battery level, which includes a charging current acquiring module, an estimated battery level increment obtaining module and a battery indicator controlling module. The charging current acquiring module is configured to acquire a charging current of an electronic device. The estimated battery level increment obtaining module is configured to obtain an estimated increment of the battery level of the electronic device based on the charging current. The battery indicator controlling module is configured to update a battery indicator of the electronic device based on the estimated increment of the battery level of the electronic device, where the battery indicator is configured to display the battery level and presented in percentage.

According to yet another aspect of the disclosure, the embodiments of the disclosure provide an electronic device, which includes a storage unit and a processor unit. The storage unit stores a program for displaying a battery level. The processor unit is configured to implement, when running the program for displaying a battery level, operations of the method for displaying a battery level.

According to still another aspect of the disclosure, the embodiments of the disclosure provide a computer storage medium. The computer storage medium stores a program for displaying battery level which, when being executed by at least one processor, cause the operations of the method for displaying a battery level to be implemented.

In the embodiments, by acquiring the charging current of the electronic device, the estimated increment of the battery level in the next time period is estimated based on the charging current. Then, a currently displayed battery level is updated by adding the estimated increment of the battery level to the level corresponding to the currently displayed battery level, rather than waiting for the battery level measured by the power meter. Thus, the embodiments enable the battery level to be displayed continuously.

In addition, an update frequency of the battery level on a display interface can be flexibly controlled. By reasonably setting the update frequency, the increment of the displayed battery level can come to a decimal place, thereby making it easier for the user to more precisely know the charging process and the charging speed.

Furthermore, in the embodiments, the estimated increment of the battery level is estimated by using the charging current, such that the estimated increment of the battery level is relatively accurate. The embodiments provided in the disclosure are different from the solutions in which the battery level is continuously displayed with an accuracy of decimal place by simply averaging the acquired values; in particular, in such solutions, the displayed battery level is not based on the current charging rate, and the increment of the battery level is constant throughout the whole charging process. On the contrary, in the solutions provided by the embodiments of the disclosure, the unit increment of the battery indicator is obtained based on an estimated growth rate of the battery level. Since the estimated growth rate of the battery level in percentage changes at each stage in the charging process, the estimated increment of the battery level varies at different stages in the entire charging process. Therefore, the solutions of displaying the battery level provided by the embodiments of the disclosure have a high accuracy.

Based on the above, the method for displaying a battery level provided by the embodiments of the disclosure can improve the continuity and the accuracy of the battery level displayed by the battery indicator.

### BRIEF DESCRIPTION OF THE DRAWINGS

FIG. 1 is a schematic structural diagram illustrating an electronic device according to embodiments of the disclosure;
FIG. 2 is a flowchart illustrating a method for displaying a battery level according to the embodiments of the disclosure;
FIG. 3 is a flowchart illustrating another method for displaying a battery level according to the embodiments of the disclosure;
FIG. 4 is a flowchart illustrating yet another method for displaying a battery level according to the embodiments of the disclosure;
FIG. 5 illustrates a flowchart of operation S233 illustrated in FIG. 4;
FIG. 6 is a structural block diagram illustrating an apparatus for displaying a battery level according to the embodiments of the disclosure; and
FIG. 7 is a structural block diagram illustrating a system architecture of the electronic device according to the embodiments of the disclosure.

### DETAILED DESCRIPTION OF PREFERRED EMBODIMENTS

Although the disclosure may be readily implemented in embodiments in different forms, only some of the specific embodiments are shown in the drawings and described in detail in the description. It can be understood that the description should be regarded as an exemplary description of principles of the disclosure, and are not intended to limit the disclosure to those described herein.

Thus, one feature indicated in the description will be configured to describe one of the features of one embodiment of the disclosure, rather than implying that each embodiment of the disclosure must have the described feature. In addition, it should be noted that many features are described in the description. While some features may be combined to illustrate potential system designs, these features may also be used in other combinations which are not explicitly described. Thus, the described combinations are not intended to be limiting, unless otherwise expressly noted.

In the embodiments illustrated in the drawings, representations of directions (such as up, down, left, right, front, rear, top, and bottom) are used for explaining structure and movement of various elements of the disclosure in a relative rather than absolute manner. These representations are appropriate when the elements are at the position illustrated in the drawings. If description of the positions of the elements changes, these representations of directions will be changed accordingly.

Exemplary embodiments will now be described more comprehensively with reference to the drawings. However, the exemplary embodiments may be implemented in various forms and should not be understood as limited to the examples described herein. Rather, the exemplary embodiments are provided to make description of the disclosure more comprehensive and complete, and fully convey the concept of the exemplary embodiments to those skilled in the art. The drawings are merely schematic illustrations of the disclosure, and are not necessarily drawn to scale. Same reference numerals in the drawings represent same or similar portions, and thus repetitions of the same reference numerals will be omitted.

Preferred embodiments of the disclosure will be further described in detail below in conjunction with the drawings of the description.

A method for displaying a battery level is provided by the embodiments of the disclosure, and can be applied to a smart terminal and a mobile terminal device, which are provided with a battery-powered system. A device to-be-charged may be, for example, a terminal or a communication terminal which includes, but is not limited to, devices that receive and send communication signals through any one or some of the following connections: a wired connection, for example, the connection is established via public switched telephone network (PSTN), digital subscriber line (DSL), a digital cable or direct cable; and/or another data connection/network, for example, the connection is established via a wireless interface for cellular network, wireless local area network (WLAN), digital TV network such as digital video broadcasting handheld (DVB-H) network, satellite network, or amplitude modulation-frequency modulation (AM-FM) broadcast transmitter, and/or a wireless interface of another communication terminal. The communication terminal configured to communicate through the wireless interface may be referred to as a "wireless communication terminal", a "wireless terminal" and/or a "mobile terminal". Examples of the smart terminal include, but are not limited to, a satellite or cellular phone; a personal communication system (PCS) terminal that can combine a cellular radio phone with data processing, faxing and data communication capabilities; a personal digital assistant (PDA) that can incorporate a radio phone, a pager, Internet/intranet accessing, a web browser, a memo pad, calendar and/or a global positioning system (GPS) receiver; and conventional laptop and/or handheld receiver or other electronic device including a radio phone transceiver. In addition, the terminal may further include, but is not limited to a rechargeable electronic device 10 provided with a charging function, such as an e-book reader, a smart wearable device, a portable power source (such as a portable charger and a travel charger), an electronic cigarette, a wireless mouse, a wireless keyboard, a wireless headset, or a Bluetooth speaker.

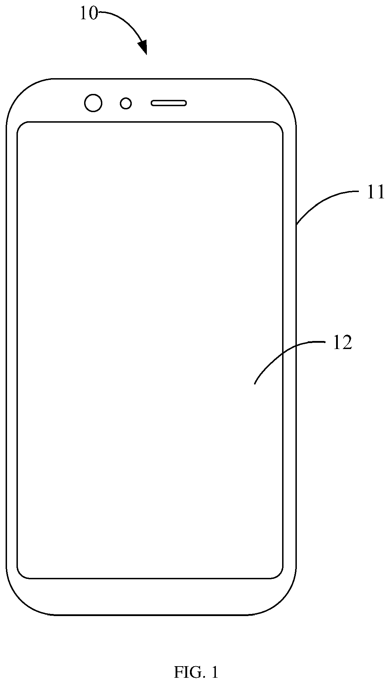

Referring to FIG. 1, the electronic device 10 may include a rear housing 11, a display screen 12, a circuit board and a battery. It should be noted that, the electronic device 10 is not limited to these components. The rear housing 11 may define an external contour of the electronic device 10. In some embodiments, the rear housing 11 may be a metal rear housing, which is made from metals such as magnesium alloy or stainless steel. It should be noted that, in the embodiments of the disclosure, the material of the rear housing 11 is not limited thereto, and other materials may also be adopted. For example, the rear housing 11 may be a plastic rear housing, a ceramic rear housing or a glass rear housing.

The display screen 12 is mounted to the rear housing 11. The display screen 12 is electrically connected to the circuit board to provide a display surface of the electronic device 10. In some embodiments, a non-display region may be provided on the display surface of the electronic device 10. For example, the non-display region may be formed on a top and/or a bottom of the electronic device 10. In other words, the electronic device 10 is provided with the non-display region, which is formed on a top and/or a bottom of the display screen 12. The non-display region of the electronic device 10 may be configured for mounting of components, such as a camera or a receiver. It should be noted that the display surface of the electronic device 10 may not be provided with the non-display region. In other words, the display screen 12 may be a full screen. As such, the display screen may be laid on the entire display surface of the electronic device 10 and, therefore, the display screen can display in full screen on the display surface of the electronic device 10.

The display screen 12 may be any of a liquid crystal display, an organic light emitting diode display, an electronic ink display, a plasma display, a display using other display technologies, or a combination thereof. The display screen 12 may include a touch sensor array (that is, the display screen 12 may be a touch sensitive display screen). The touch sensor may be a capacitive touch sensor formed by an array of transparent touch sensor electrodes (such as indium tin oxide (ITO) electrodes). Alternatively, the touch sensor may be formed by using other touch technologies, such as acoustic touch, pressure-sensitive touch, resistive touch, optical touch, which is not limited in the embodiments of the disclosure.

It should be noted that, in some embodiments, a cover plate may be arranged on the display screen 12, and cover the display screen 12 to protect the display screen 12. The cover plate may be a transparent glass cover plate, such that the display screen 12 may display information through the cover plate. In some embodiments, the cover plate may be a glass cover plate made from a material such as sapphire. In some embodiments, an accommodation space is formed between the rear housing 11 and the display screen 12, after the display screen 12 is mounted on the rear housing 11. The accommodation space can accommodate components of the electronic device 10, such as, the circuit board or the battery. The circuit board is mounted in the rear housing 11, and the circuit board may serve as the main board of the electronic device 10. The electronic device may be integrated thereon with one, two or more functional components, such a motor, a microphone, a speaker, a headphone interface, a universal serial bus interface, a camera, a distance sensor, an ambient light sensor, a receiver, a controller.

In some embodiments, the circuit board may be fixed in the rear housing 11. Specifically, the circuit board may be screwed onto the rear housing 11 by using a screw, or may be snapped into the rear housing 11 by using a snap. It should be noted that, in the embodiments of the disclosure, the specific manner in which the circuit board is fixed to the rear cover 11 may not be limited to this. The circuit board may be fixed to the rear housing 11 in other manner, for example, by using both of the snap and the screw. The battery is mounted in the rear housing 11, and the battery 11 is electrically connected to the circuit board to supply power to the electronic device 10. The rear housing 11 may serve as a battery cover for the battery. The rear housing 11 covers the battery, to protect the battery and reduce damage to the battery caused by collisions, drops of the electronic device 10, and the like.

The electronic device 10 may include an input-output circuit, which may be disposed on the circuit board. The input-output circuit may be configured to enable the electronic device 10 to realize the input and output of data, that is, to allow the electronic device 10 to receive data from an external device and output data to the external device from the electronic device 10. The input-output circuit may further include a sensor. The sensor may include an ambient light sensor, a proximity sensor based on light and capacitance, a touch sensor (such as a light type touch sensor and/or a capacitive touch sensor, in which the touch sensor may be a part of the touch display screen, or may serve as an independent touch sensor structure), an acceleration sensor, a temperature sensor, and other sensors.

The electronic device 10 may further include a power management circuit and other input-output units. The input-output units may include a button, a joystick, a click wheel, a scroll wheel, a touch pad, a keypad, a numpad, a camera, a light-emitting diode, and other state indicators.

The user can control the operations of the electronic device 10 by inputting commands through the input-output circuit, and receive status information and other outputs from the electronic device 10 by using the data output from the input-output circuit.

The electronic device 10 further includes a charging circuit. The charging circuit can charge a battery cell of the electronic device 10. The charging circuit may be further used to regulate a charging voltage and/or a charging current input from an adapter, thereby meeting charging requirements of the battery.

The electronic device 10 is configured with a charging interface, such as, a universal serial bus (USB) 2.0 interface, a Micro USB interface or a USB TYPE-C interface. In some embodiments, the charging interface may also be a lightning interface, or a parallel interface or serial interface of any other type which can be used for charging. The charging interface is connected to the adapter through a data cable. The adapter acquires electrical energy from the mains supply and, after a voltage conversion, transmits the electrical energy to the charging circuit through the data cable and the charging interface, such that the electrical energy is input into the battery cell to-be-charged through the charging circuit.

The battery provided by the embodiments of the disclosure includes a casing, a battery cell wrapped the casing, a battery protection board, etc. The battery protection board is an integrated circuit board for protecting the battery cell. The battery protection board is generally provided with a sampling circuit and a protection circuit. The battery may include a single battery cell or multiple battery cells. In a case that the battery includes the multiple battery cells, the multiple battery cells may be connected in series with each other. As such, an affordable charging voltage of the battery is a sum of an affordable charging voltage of the multiple battery cells, the charging speed can be increased and the heat caused by the charging can be reduced.

A method for displaying a battery level is provided by the embodiments of the disclosure, by which the battery level can be displayed continuously and the accuracy of the displayed battery level can be improved. The method for displaying a battery level in the embodiments of the disclosure can be used to continuously display a change of the battery level in real time during the charging process of the electronic device 10, and can be used when the electronic device 10 is in a working state or a standby state. Those skilled in the art can also realize the continuous displaying of the battery level in real time during a discharging process, with reference to the concept of the disclosure. In the following embodiments, the method for displaying a battery level during the charging process of the electronic device 10 is illustrated.

In the embodiments of the disclosure, the battery level is displayed through the battery indicator and presented in percentage, and the battery level displayed through the battery indicator in percentage is referred to as battery level for short in the following embodiments. The battery level is obtained as follows. The battery level equals to a value obtained by dividing a remaining battery capacity by a total available battery capacity, where the remaining battery capacity refers to a currently available power capacity of the battery. During the charging process, as the electrical energy is continuously charged into the battery, the remaining battery capacity is continuously increased, and the battery level increases accordingly. The value of the battery level ranges from 0% to 100%, that is, the battery indicator is displayed in percentage.

In the related art, the battery level measured by a power meter is an integer value. In the embodiments of the disclosure, the battery level is displayed in real time, and in order to display the battery level more precisely, the displayed battery level includes an integer portion and a decimal portion in the following embodiments. The decimal portion may include one decimal place or two decimal places.

In the embodiments, the battery level may be displayed on a standby interface of the electronic device 10 during the charging process. When the electronic device 10 is in the working state, the battery level may be displayed in a battery icon on the display interface.

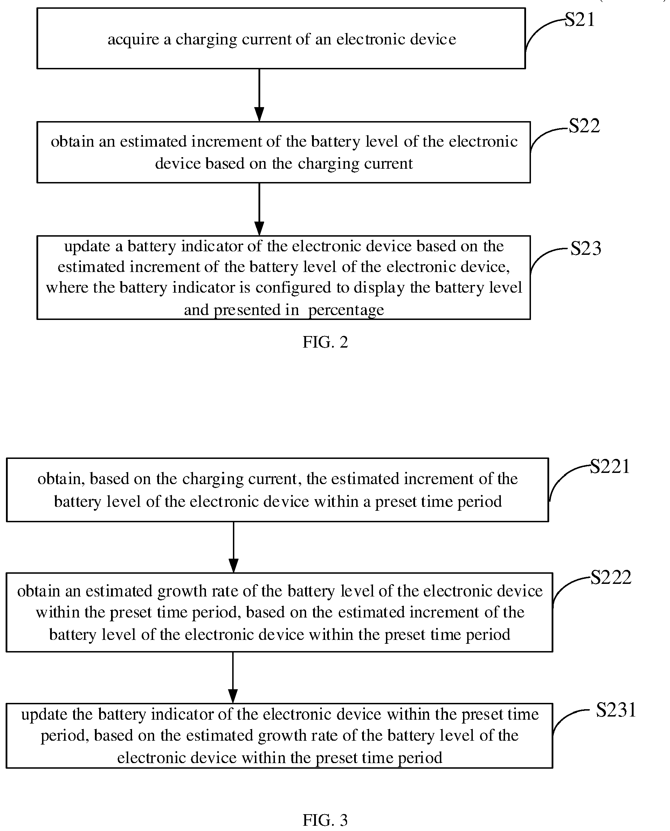

Referring to FIG. 2, a flowchart illustrating a method for displaying a battery level according to the embodiments of the disclosure is illustrated. In the embodiments, the method for displaying a battery level includes blocks S21, S22 and S23.

At block S21, a charging current of a battery in the electronic device 10 is acquired.

Specifically, the charging current of the battery can be measured by the power meter in the electronic device 10. Alternatively, the charging current of the battery may be detected by a current sensor.

At block S22, an estimated increment of the battery level of the electronic device is obtained based on the charging current.

In the embodiments, the estimated increment of the battery level within a next time period can be obtained based on the acquired charging current. It can be understood that, in a case that the charging current is relatively constant within a certain time period, the next time period within which the estimated increment of the battery level is obtained may be long. In a case that the charging current is poor in stability within a certain time period, the next time period within which the estimated increment of the battery level is obtained may be short. Thus, a specific time period, within which the estimated increment of the battery level is obtained, can be set flexibly based on a current charging mode.

At Block S23, a battery indicator of the electronic device is updated based on the estimated increment of the battery level of the electronic device, where the battery indicator is configured to display the battery level and presented in percentage.

Once the estimated increment of the battery level is acquired, it is possible to flexibly set a display mode for the battery level. For example, in a case that the obtained estimated increment of the battery level refers to that the battery level is increased by 2 within the next 10 seconds, the battery indicator may be presented in such a manner that the displayed battery level is increased by 2 within the next 10 seconds. There is no restriction on whether the battery level is increased uniformly or non-uniformly.

In the embodiments, by acquiring the charging current of the battery in the electronic device, the estimated increment of the battery level in the next time period is estimated based on the charging current. Then, a currently displayed battery level is updated by adding the estimated increment of the battery level to the level corresponding to the currently displayed battery level, rather than waiting for the battery level measured by the power meter. Thus, the embodiments enable the battery level to be displayed continuously.

In addition, an update frequency of the battery level on a display interface can be flexibly controlled. By reasonably setting the update frequency, the increment of the displayed battery level can come to the decimal place, thereby making it easier for the user to more precisely know the charging process and the charging speed.

Furthermore, in the embodiments, the estimated increment of the battery level is estimated by using the charging current, such that the estimated increment of the battery level is relatively accurate. The embodiments provided in the disclosure are different from the solutions in which the battery level is continuously displayed with an accuracy of decimal place by simply averaging the acquired values; in particular, in such solutions, the displayed battery level is not based on the current charging rate, and the increment of the battery level is constant throughout the whole charging process. On the contrary, in the solutions provided by the embodiments of the disclosure, the unit increment of the battery indicator is obtained based on an estimated growth rate of the battery level. Since the estimated growth rate of the battery level in percentage changes at each stage in the charging process, the estimated increment of the battery level varies at different stages in the entire charging process. Therefore, the solutions of displaying the battery level provided by the embodiments of the disclosure have a high accuracy.

Based on the above, the method for displaying a battery level provided by the embodiments of the disclosure can improve the continuity and the accuracy of the battery level displayed by the battery indicator.

In order to enable the displayed battery level to be increased uniformly so that the user can know an average increase speed of the current battery level, in the embodiments, an estimated growth rate is obtained for the uniform increase of the displayed battery level. Referring to FIG. 3, the obtaining the estimated increment of the battery level based on the charging current specifically includes blocks S221, S222 and S231.

At block S221, the estimated increment of the battery level within a preset time period is obtained based on the charging current.

In some embodiments, an average charging current, within a previous time period just before the current time period, of the electronic device 10 may be obtained, and the average charging current is used as a basis for obtaining the estimated growth rate of the battery level. In the embodiments, the charging current of the electronic device 10 corresponding to the beginning of the preset time period is acquired.

At block S222, an estimated growth rate of the battery level within the preset time period is obtained, based on the estimated increment of the battery level within the preset time period.

In the embodiments, the estimated growth rate of the battery level within the preset time period is obtained, based on the current charging current. The preset time period can be set arbitrarily. Specifically, the preset time period can be set based on the current charging mode of the electronic device 10, the computing resource of the electronic device 10, an accuracy requirement of the battery level, and the like. The shorter the preset time period, the more accurate the obtained battery level. However, a long preset time period can reduce the resource consumption of the electronic device 10.

The estimated growth rate may refer to an estimated increment of the battery level within one second. In an example, when the preset time period is 5 seconds, and the estimated increment of the battery level is 0.65, the estimated growth rate of the battery level within the next 5 seconds is 0.13.

Thus, as be seen that, a constant unit increment of the displayed battery level within the preset time period is enabled by obtaining the estimated growth rate. As such, the user can better know the charging speed within the current time period.

The block S23 of updating the battery indicator based on the estimated increment of the battery level includes block S231.

At block S231, the battery indicator is updated within the preset time period, based on the estimated growth rate of the battery level.

The battery level is generally displayed on the display interface of the electronic device 10. In the embodiments, it is illustrated by taking the display screen as an example. After the estimated increment of the battery level is determined, there are at least two implementations for setting the display mode of the battery level.

In an implementation, each time the battery level displayed through the battery indicator is updated, a unit increment of the displayed battery level, i.e., a unit increment of the battery indicator, is a preset value, and an update frequency of the battery indicator is determined through calculation. Specifically, the updating the battery indicator based on the estimated growth rate of the battery level includes the following operations:
Setting a unit increment of the battery indicator for each updating of the battery indicator of the electronic device;
Obtaining a ratio of the estimated growth rate of the battery level of the electronic device to the unit increment of the battery indicator, to determine an update frequency of the battery indicator; and
Increasing the displayed battery level by the unit increment of the battery indicator whenever the battery indicator of the electronic device is updated based on the update frequency of the battery indicator.

In conjunction with the above example in which the estimated growth rate of the battery level within the next 5 seconds is 0.13, when the unit increment of the battery indicator is set as 0.01, the update frequency of the battery indicator is determined as 13 times per second. Thus, the estimated increment of the battery level reaches exactly 0.65 after 5 seconds.

In another implementation, each time the battery level displayed through the battery indicator is updated, an update frequency of the battery indicator is a preset value, and a unit increment of the battery indicator is determined through calculation. Specifically, the updating of the battery indicator based on the estimated growth rate of the battery level includes the following operations:
Acquiring an update frequency of the battery indicator;
Obtaining a ratio of the estimated growth rate of the battery level of the electronic device to the update frequency of the battery indicator, to determine a unit increment of the battery indicator; and
Increasing the displayed battery level by the unit increment of the battery indicator, whenever the battery indicator of the electronic device is updated based on the update frequency of the battery indicator.

In conjunction with the above example in which the estimated growth rate of the battery level within the next 5 seconds is 0.13, when the update frequency of the battery indicator is set as 10 times per second, the unit increment of the battery indicator is determined as 0.013. Thus, the estimated increment of the battery level reaches exactly 0.65 after 5 seconds.

It should be noted that, when the battery indicator is precise to two decimal places, the battery indicator cannot be increased by an exact 0.013; in this case, the displayed battery level may be uniformly increased in stages, as long as the estimated increment of the battery level reaches exactly 0.65 after 5 seconds.

In the embodiments, the unit increment of the battery indicator is less than 1. The displayed battery level described herein refers to the value preceding the percentage sign. Therefore, by setting the unit increment of the battery indicator or the update frequency of the battery indicator, the decimal portion and integer portion of the displayed battery level are enabled to be uniformly increased, thereby reflecting the change of the battery level more precisely.

It should be noted that, an initial value of the battery level at the beginning of the charging process may not be 0. Therefore, in the embodiments, when the method is started at the beginning of the charging process, the updating the battery indicator based on the estimated growth rate of the battery level includes the following operations:
Acquiring an initial remaining battery capacity and a total available battery capacity;
Obtaining a ratio of the initial remaining battery capacity to the total available battery capacity, to determine an initial battery level; and
Updating the battery indicator, based on the estimated increment of the battery level and the initial battery level.

It can be understood that, after the initial battery level is determined, the battery indicator is updated based on the estimated increment of the battery level or the estimated growth rate of the battery level.

Both of the remaining battery capacity and total available battery capacity can be measured by the power meter. In the embodiments, the unit increment of the battery indicator can come to the decimal place, and therefore, the initial battery level is precise to a decimal place when the initial battery level is obtained. For example, the initial battery level can be precise to one decimal place, or two decimal places, i.e., the initial battery level is displayed as XX.YY%. Therefore, the embodiments improve the precision of the displayed battery level.

In combination with the above embodiments, in order to improve the accuracy for displaying the battery level, the current battery level is not acquired from the power meter, since the data of the power meter is updated slowly and the battery level acquired from the power meter only has an integer place without a decimal place. Rather, in the embodiments, based on the initial battery level with the decimal place, and by setting the update frequency of the battery indicator, the unit increment of the battery indicator is enabled to be less than 1. That is, the change of the displayed battery level can be precise to the decimal place each time the battery indicator is updated. Therefore, the embodiments can improve the precision of the displayed battery level.

Furthermore, the entire charging process may include at least two successive preset time periods. Within each of the preset time periods, the battery level is displayed according to the method in the above embodiments. In the embodiments, the entire charging process may be divided into multiple successive preset time periods.

Durations of the multiple successive preset time periods may be equal or unequal. For example, the preset time periods are acquired by performing a reasonable division based on the charging mode. In particular, the charging may be switched between a constant current charging state and a constant voltage charging state in some charging modes, and therefore, the corresponding preset time periods may be set based on different charging states.

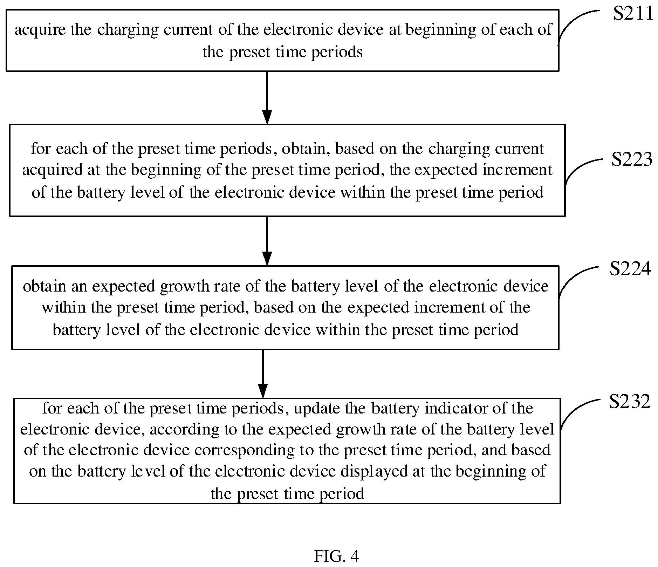

Based on the above, referring to FIG. 4, the acquiring the charging current of the electronic device includes the following operations in the embodiments.

At block S211, the charging current of the electronic device is acquired at beginning of each of the preset time periods.

Since the multiple preset time periods are successive, the end of the previous preset time period is immediately followed by the beginning of a next preset time period.

In some embodiments, an average current of the electronic device 10 within the previous preset time period may be obtained, and the obtained average charging current is used as the basis for obtaining the estimated growth rate of the battery level within the current preset time period. In the embodiments, the charging current of the electronic device 10 corresponding to the current time instant is acquired. In other words, the charging current of the electronic device 10 is acquired at the beginning of the current preset time period.

The block S22 in the above embodiments includes blocks S223 and S224.

At block S223, for each of the preset time periods, the estimated increment of the battery level within the preset time period is obtained, based on the charging current acquired at the beginning of the preset time period.

At block S224, the estimated growth rate of the battery level within the preset time period is obtained, based on the estimated increment of the battery level within the preset time period.

The block S23 of the above embodiment includes the following operation:
For each of the preset time period, the battery indicator is updated, based on the estimated growth rate of the battery level corresponding to the preset time period, and based on the battery level displayed at the beginning of the preset time period.

Therefore, the estimated growth rate of the battery level within each of the preset time periods is determined based on the charging current acquired at the beginning of the preset time period.

In the embodiments, for each of the preset time periods, the block S223 of obtaining the estimated increment of the battery level within the preset time period based on the charging current acquired at the beginning of the preset time period, includes the following operation:
Acquiring an estimated increment of the remaining battery capacity within the preset time period, based on the charging current; and
Obtaining a ratio of the estimated increment of the remaining battery capacity to of the total available battery capacity, to determine the estimated increment of the battery level within the preset time period.

In the embodiments, the block S224 of obtaining the estimated growth rate of the battery level within the preset time period based on the estimated increment of the battery level within the preset time period, includes the following operation:
Obtaining a ratio of the estimated increment of the battery level to the preset time period is obtained, to determine the estimated growth rate of the battery level within the preset time period.

From the calculation formula for the battery level, it is known that the ratio of the estimated increment of the remaining battery capacity to the total available battery capacity is the estimated increment of the battery level. The product of the acquired charging current and the preset time period may be determined as the estimated increment of the remaining battery capacity.

By obtaining the ratio of the estimated increment of the battery level and the preset time period, an estimated increment of the battery level corresponding to each second is acquired, which is the estimated growth rate of the battery level within the preset time period.

In one example, the preset time period is 5 seconds. After the current charging current is acquired, the estimated increment of the remaining battery capacity within the next 5 seconds is obtained. Specifically, it is obtained by multiplying the current charging current by 5 seconds. The ratio of the estimated increment of the remaining battery capacity to the total available battery capacity is the estimated increment of the battery level within the next 5 seconds. By dividing the estimated increment of the battery level by 5 seconds, the estimated growth rate of the battery level within the next 5 seconds is acquired.

The updating the battery indicator based on the estimated growth rate of the battery level includes the following operation:
Within each preset time period, updating the battery indicator based on the estimated growth rate of the battery level.

In the embodiments of the disclosure, in order to further improve the accuracy of the displayed battery level, an error between an actual increment and the estimated increment of the battery level within each of the preset time periods is obtained, and is compensated in the next preset time period, thereby avoiding an accumulative error.

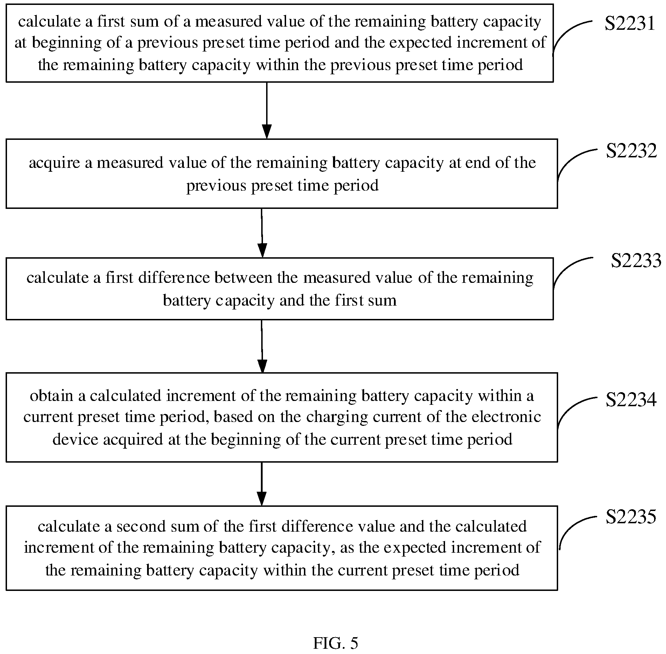

Referring to FIG. 5, it illustrates an implementation of determining the estimated increment of the remaining battery capacity for the block S223 of FIG. 4under a case where the estimated increment of the battery level within each preset time period is obtained based on the estimated increment of the remaining battery capacity.

Specifically, in the embodiments, the obtaining the estimated increment of remaining battery capacity within each preset time period based on the charging current, includes blocks S2231-S2235.

At block S2231, a first sum of a measured value of the remaining battery capacity measured at the beginning of a previous preset time period and the estimated increment of the remaining battery capacity within the previous preset time period is calculated.

At block S2232, a measured value of the remaining battery capacity measured at the end of the previous preset time period is acquired.

At block S2233, a first difference between the measured value of the remaining battery capacity and the first sum is calculated.

At block S2234, a calculated increment of the remaining battery capacity within the current preset time period is obtained, based on the charging current of the electronic device acquired at the beginning of the current preset time period.

At block S2235, a second sum of the first difference and the calculated increment of the remaining battery capacity is calculated, and the second sum is taken as the estimated increment of the remaining battery capacity within the current preset time period.

Since the multiple preset time periods are successive, the end of the previous preset time period is immediately followed by the beginning of the next preset time period. The measured value of the current remaining battery capacity is acquired from the power meter. The measured value of the current remaining battery capacity is the actual value of the remaining battery capacity corresponding to the end of the previous preset time period.

The sum of the measured value of the remaining battery capacity measured at the beginning of the previous preset time period and the estimated increment of the remaining battery capacity within the previous preset time period is a displayed value of the remaining battery capacity corresponding to the end of the previous preset time period.

By calculating the difference between the measured value of the current remaining battery capacity and the first sum, a deviation between the actual value of the remaining battery capacity and the displayed value of the remaining battery capacity at the end of the previous preset time period is acquired.

In the embodiments, the deviation is eliminated in the current preset time period. Thus, the charging current corresponding to the beginning of the current preset time period is acquired, and the calculated increment of the remaining battery capacity corresponding to the current preset time period is obtained based on the acquired charging current.

Furthermore, the obtained deviation and the calculated increment of the remaining battery capacity are added up, thereby determining the estimated increment of the remaining battery capacity corresponding to the current preset time period. And then, the estimated growth rate of the battery level is obtained based on the estimated increment of the remaining battery capacity.

In a specific example, the battery level obtained at the beginning of a certain preset time period is 1.01, the estimated increment of the battery level within the preset time period is 0.51 (the corresponding battery level is 1.52), and the actual value of the estimated increment of the battery level at the end of this preset time period is 0.54 (the corresponding battery level is 1.55). The estimated increment of the battery level is obtained as 0.46 for the next preset time period. Since the obtained battery level only increased to 1.52 within the previous preset time period, which is 0.03 less than the actual value 1.55, and therefore, the estimated increment of the battery level within the next preset time period is 0.03+0.46.

By performing the above operations, at the end of the current preset time period, the deviation of the battery level generated in the previous preset time period has been corrected. Thus, the embodiments further improve the accuracy of the displayed battery level.

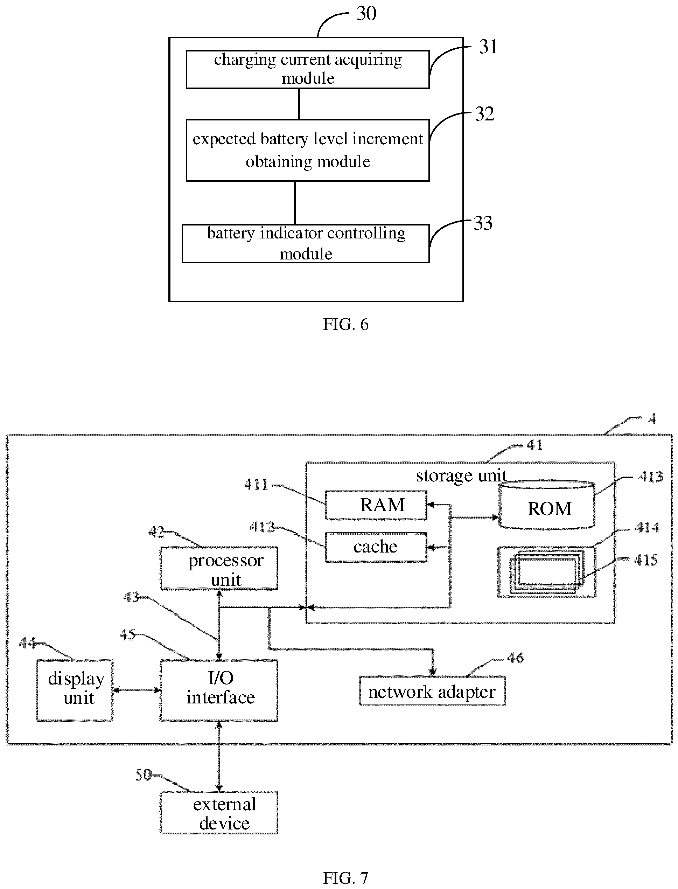

An apparatus for displaying a battery level is further provided by the embodiments of the disclosure. The specific embodiments of the apparatus for displaying the battery capacity are referred to the above method for displaying a battery capacity. Specifically, referring to FIG. 6, the apparatus for displaying a battery level 30 includes a charging current acquiring module 31, an estimated battery level increment obtaining module 32 and a battery indicator controlling module 33.

The charging current acquiring module 31 is configured to acquire a charging current of an electronic device.

The estimated battery level increment obtaining module 32 is configured to obtain an estimated increment of the battery level, based on the charging current.

The battery indicator controlling module 33 is configured to update a battery indicator of the electronic device based on the estimated increment of the battery level of the electronic device, where the battery indicator is configured to display the battery level and presented in percentage.

In some embodiments, with regard to obtaining the estimated increment of the battery level based on the charging current, the apparatus for displaying a battery level 30 further includes an estimated battery level growth rate obtaining module.

The estimated battery level growth rate obtaining module is configured to obtain an estimated growth rate of the battery level within the preset time period, based on the expected increment of the battery level within the preset time period.

The battery indicator controlling module 33 is configured to update the battery indicator within the preset time period, based on the estimated growth rate of the battery level of within the preset time period.

In some embodiments, the charging current acquiring module 31 is further configured to acquire the charging current of the electronic device at beginning of each of the preset time periods.

The estimated battery level growth rate obtaining module is configured to determine the estimated growth rate of the battery level within the preset time period, based on the charging current acquired at the beginning of the preset time period.

The battery indicator controlling module 33 is specifically configured to update the battery indicator within the preset time period based on the estimated growth rate of the battery level within the preset time period.

In some embodiments, the charging current acquiring module 31 is further configured to acquire a current charging current of a battery at beginning of each of the preset time periods.

In some embodiments, the estimated battery level growth rate obtaining module is configured to obtain an estimated increment of a remaining battery capacity within the preset time period, based on the charging current; obtain a ratio of the estimated increment of the remaining battery capacity to a total available battery capacity, to determine the estimated increment of the battery level within the preset time period; and obtain a ratio of the estimated increment of the battery level to the preset time period, to determine the estimated growth rate of the battery level within the preset time period.

In some embodiments, the charging process includes multiple successive preset time periods. With regard to obtaining the estimated increment of the remaining battery capacity within the preset time period based on the charging current, the apparatus for displaying a battery level 30 further includes an acquiring module and a obtaining module.

The acquiring module is configured to acquire a measured value of a current remaining battery capacity measured at end of a previous preset time period.

The obtaining module is configured to calculate a first sum of a measured value of the remaining battery capacity measured at beginning of the previous preset time period and the estimated increment of the remaining battery capacity within the previous preset time period; calculate a first difference between the measured value of the current remaining battery capacity and the first sum; obtain a calculated increment of the remaining battery capacity within a current preset time period, based on a current charging current; and calculate a sum of the first difference and the calculated increment, as the estimated increment of the remaining battery capacity within the current preset time period.

In some embodiments, the acquiring module is further configured to acquire a current remaining battery capacity and a current total available battery capacity at beginning of each of the preset time periods.

The obtaining module is further configured to obtain a ratio of the current remaining battery capacity to the current total available battery capacity, to determine a current battery level.

In some embodiments, the obtained initial battery level is precise to a decimal place.

In some embodiments, the apparatus for displaying a battery level 30 further includes a unit increment setting module and a obtaining module.

The unit increment setting module is configured to set a unit increment of the battery indicator for each updating of the battery indicator.

The obtaining module is further configured to obtain the estimated growth rate of the battery level and the unit increment of the battery indicator, to determine an update frequency of the battery indicator.

The battery indicator controlling module 33 is configured to increase a currently displayed battery level by the unit increment of the battery indicator, whenever the battery indicator is updated, and based on the currently displayed battery level.

In some embodiments, the acquiring module is further configured to acquire an update frequency of the battery indicator.

The obtaining module is further configured to obtain the estimated growth rate of the battery level and the update frequency of the battery indicator, to determine a unit increment of the battery indicator.

The battery indicator controlling module 33 is configured to increase a currently displayed battery level by the unit increment of the battery indicator, whenever the battery indicator is updated, and based on the currently displayed battery level.

In some embodiments, the unit increment of the battery indicator is less than 1.

Referring to FIG. 7, the electronic device 10 is embodied in a general-purpose computing device. Components of the electronic device 10 may include, but are not limited to: at least one processing unit 42, at least one storage unit 41, and a bus 43 connecting different system components (including the storage unit 420 and the processing unit 410). The storage unit 41 stores program code therein, and the program code may be executed by the processing unit 42, to cause the processing unit 42 to perform the operations according to various exemplary embodiments of the disclosure.

The storage unit 41 may include a readable medium in the form of a volatile storage unit, for example, a random access memory (RAM) 411 and/or a cache storage unit 412, and may further include a read-only memory (ROM) 413.

The storage unit 41 may further include a program/utility tool 414 having a group of (at least one) program modules 415. Such program modules 415 include, but are not limited to, an operating system, one or more application programs, other program modules, and program data. Each or a combination of these examples may be implemented in a network environment.

The bus 43 may represent one or more of several types of bus structures, which include a storage unit bus or storage unit controller, a peripheral bus, an accelerated graphics port, a processing unit, or a local bus using any of multiple bus structures.

The electronic device 10 may also communicate with one or more external devices 50 (such as a keyboard, a pointing device, and a Bluetooth device). Alternatively, the electronic device 10 may also communicate with one or more devices that enable a user to interact with the electronic device 10, and/or communicate with any device (such as a router, a modem, or the display unit 44) that enables the electronic device 10 of a robot to communicate with one or more other computing devices. Such communication may be performed through an input/output (I/O) interface 45. In addition, the electronic device 10 of the robot may further communicate with one or more networks (such as a local area network (LAN), a wide area network (WAN), and/or a public network, for example, the Internet) through a network adapter 46. As shown in FIG. 7, the network adapter 46 communicates with other modules of the electronic device 10 of the robot through the bus 43. It should be understood that, although not shown in FIG. 7, other hardware and/or software module may be used in conjunction with the electronic device 10 of the robot, including, but not limited to microcode, a device driver, a redundancy processing unit, an external disk drive array, a RAID system, a tape drive, a data backup storage system, or the like.

Through descriptions of the foregoing embodiments, it is easy for those skilled in the art to understand that the exemplary embodiments described herein can be implemented by software or by combining the software with necessary hardware. Therefore, the technical solutions of the embodiments of the disclosure may be implemented in the form of a software product. The software product may be stored in a non-volatile storage medium (which may be a compact disc read-only memory (CD-ROM), a USB flash drive, a removable hard disk, or the like) or in a network. The software product includes several instructions for instructing a computer device (which may be a personal computer, a server, a terminal device, a network device, or the like) to perform the methods according to the embodiments of the disclosure.

In the exemplary embodiments of the disclosure, a computer-readable storage medium is further provided. The computer-readable storage medium stores therein a program product, which is capable of implementing the above method of the specification. In some possible embodiments, various aspects of the disclosure can also be implemented in the form of a program product which includes program codes. When the program product is running on a terminal device, the program codes cause the terminal device to perform the instructions according to various exemplary embodiments of the disclosure.

Although the disclosure is described with reference to some exemplary embodiments, it should be understood that, terms used herein are illustrative and exemplary, but not limiting. Because the disclosure may be implemented in various manner without departing from the spirit and the essence of the disclosure, it should be understood that, the above embodiments are not limited to any details described above, and should be widely explained within the spirit and the scope defined by the appended claims. Therefore, all the changes and modifications falling within the scope of the claims or the equivalents should be encompassed by the appended claims.

## Claims

1. A method for displaying a battery level, comprising:
acquiring a charging current of an electronic device;
obtaining an estimated increment of the battery level of the electronic device based on the charging current; and
updating a battery indicator of the electronic device based on the estimated increment of the battery level of the electronic device, wherein the battery indicator is configured to display the battery level and presented in percentage.

2. The method as claimed in claim 1, wherein the obtaining an estimated increment of the battery level of the electronic device based on the charging current, comprises:
obtaining, based on the charging current, the estimated increment of the battery level of the electronic device within a preset time period; and
obtaining an estimated growth rate of the battery level of the electronic device within the preset time period, based on the estimated increment of the battery level of the electronic device within the preset time period; and
wherein the updating a battery indicator of the electronic device based on the estimated increment of the battery level of the electronic device, comprises:
updating the battery indicator of the electronic device within the preset time period, based on the estimated growth rate of the battery level of the electronic device within the preset time period.

3. The method as claimed in claim 2, wherein a charging process of the electronic device comprises at least two successive preset time periods;
wherein the acquiring a charging current of an electronic device comprises:
acquiring the charging current of the electronic device at beginning of each of the preset time periods;
wherein the obtaining an estimated increment of the battery level of the electronic device based on the charging current, comprises:
for each of the preset time periods, obtaining, based on the charging current acquired at the beginning of the preset time period, the estimated increment of the battery level of the electronic device within the preset time period; and
obtaining an estimated growth rate of the battery level of the electronic device within the preset time period based on the estimated increment of the battery level of the electronic device within the preset time period; and
wherein the updating the battery indicator of the electronic device based on the estimated growth rate of the battery level of the electronic device, comprises:
for each of the preset time periods, updating the battery indicator of the electronic device, based on the estimated growth rate of the battery level of the electronic device corresponding to the preset time period and the battery level of the electronic device displayed at the beginning of the preset time period.

4. The method as claimed in claim 3, wherein the obtaining, for each of the preset time periods, the estimated increment of the battery level of the electronic device within the predetermined time period based on the charging current acquired at the beginning of the predetermined time period, comprises:
obtaining, based on the charging current, an estimated increment of a remaining battery capacity of the electronic device within the preset time period; and
obtaining a ratio of the estimated increment of the remaining battery capacity to a total available battery capacity of the electronic device, to determine the estimated increment of the battery level of the electronic device within the preset time period; and
wherein the obtaining an estimated growth rate of the battery level of the electronic device within the preset time period based on the estimated increment of the battery level of the electronic device within the preset time period, comprises:
obtaining a ratio of the estimated increment of the battery level of the electronic device to the preset time period, to determine the estimated growth rate of the battery level of the electronic device within the preset time period.

5. The method as claimed in claim 4, wherein the obtaining, based on the charging current, an estimated increment of a remaining battery capacity of the electronic device within the preset time period, comprises:
calculating a first sum of a measured value of the remaining battery capacity measured at beginning of a previous preset time period and the estimated increment of the remaining battery capacity within the previous preset time period;
acquiring a measured value of the remaining battery capacity measured at end of the previous preset time period;
calculating a first difference between the measured value of the remaining battery capacity and the first sum;
obtaining a calculated increment of the remaining battery capacity within a current preset time period, based on the charging current of the electronic device acquired at the beginning of the current preset time period; and
calculating a second sum of the first difference and the calculated increment of the remaining battery capacity, as the estimated increment of the remaining battery capacity within the current preset time period.

6. The method as claimed in claim 2, wherein the updating the battery indicator of the electronic device based on the estimated growth rate of the battery level of the electronic device, comprises:
setting a unit increment of the battery indicator for each updating of the battery indicator of the electronic device;
obtaining a ratio of the estimated growth rate of the battery level of the electronic device to the unit increment of the battery indicator, to determine an update frequency of the battery indicator; and
increasing a displayed battery level by the unit increment of the battery indicator, whenever the battery indicator of the electronic device is updated according to the update frequency of the battery indicator.

7. The method as claimed in claim 2, wherein the updating the battery indicator of the electronic device based on the estimated growth rate of the battery level of the electronic device, comprises:
acquiring an update frequency of the battery indicator;
obtaining a ratio of the estimated growth rate of the battery level of the electronic device to the update frequency of the battery indicator, to determine a unit increment of the battery indicator; and
increasing a displayed battery level by the unit increment of the battery indicator, whenever the battery indicator of the electronic device is updated based on the update frequency of the battery indicator.

8. The method as claimed in claim 6 or 7, wherein the unit increment of the battery indicator is less than 1.

9. The method as claimed in any one of claims 1-7, wherein when the method is started at beginning of a charging process, the updating the battery indicator of the electronic device based on the estimated growth rate of the battery level of the electronic device, comprises:
acquiring an initial remaining battery capacity and a total available battery capacity of the electronic device;
obtaining a ratio of the initial remaining battery capacity to the total available battery capacity, to determine an initial battery level of the electronic device; and
updating the battery indicator of the electronic device, based on the estimated increment of the battery level of the electronic device and the initial battery level of the electronic device.

10. The method as claimed in claim 9, wherein the obtained initial battery level is precise to a decimal place.

11. An apparatus for displaying a battery level, comprising:
a charging current acquiring module, configured to acquire a charging current of an electronic device;
an estimated battery level increment obtaining module, configured to obtain an estimated increment of the battery level of the electronic device based on the charging current; and
a battery indicator controlling module, configured to update a battery indicator of the electronic device based on the estimated increment of the battery level of the electronic device, wherein the battery indicator is configured to display the battery level and presented in percentage.

12. The apparatus as claimed in claim 11, further comprising:
an estimated growth rate obtaining module, configured to obtain an estimated growth rate of the battery level within a preset time period, based on the estimated increment of the battery level within the preset time period; and
wherein the battery indicator controlling module is further configured to update the battery indicator of the electronic device within the preset time period, based on the estimated growth rate of the battery level within the preset time period.

13. The apparatus as claimed in claim 12, wherein the charging current acquiring module is further configured to acquire the charging current of the electronic device at beginning of each of preset time periods;
wherein the estimated battery level increment obtaining module is further configured to obtain the estimated increment of the battery level of the electronic device within the preset time period, based on the charging current acquired at the beginning of the preset time period; and
wherein the estimated growth rate obtaining module is further configured to obtain the estimated growth rate of the battery level of the electronic device within the preset time period, based on the estimated increment of the battery level of the electronic device within the preset time period.

14. An electronic device, comprising:
a storage unit, storing a program for displaying a battery level; and
a processor unit, configured to implement, when running the program for displaying a battery level, operations of the method for displaying a battery level as claimed in any one of claims 1-10.

15. A computer storage medium, wherein the computer storage medium stores a program for displaying a battery level which, when being executed by at least one processor, causes instructions of the method for displaying a battery level as claimed in any one of claims 1-10 to be implemented.
